Europäisches Patentamt

European Patent Office

Office européen des brevets

(11) Veröffentlichungsnummer: **0 065 210**
**B1**

(12) **EUROPÄISCHE PATENTSCHRIFT**

(45) Veröffentlichungstag der Patentschrift:
**28.01.87**

(51) Int. Cl.⁴: **H 03 H 17/06,** H 03 H 17/02

(21) Anmeldenummer: **82103859.3**

(22) Anmeldetag: **05.05.82**

(54) **Verfahren zur Aufbereitung elektrischer Signale mit einer digitalen Filteranordnung.**

(30) Priorität: **09.05.81 DE 3118473**

(43) Veröffentlichungstag der Anmeldung:
**24.11.82 Patentblatt 82/47**

(45) Bekanntmachung des Hinweises auf die Patenterteilung:
**28.01.87 Patentblatt 87/5**

(84) Benannte Vertragsstaaten:
**CH DE FR GB LI NL SE**

(56) Entgegenhaltungen:
DE - A - 2 426 451
DE - B - 1 273 002

PROCEEDINGS OF THE IEEE, Band 69, Nr. 3, März 1981,
Seiten 300-331, New York, USA R.E. CROCHIERE et al.:
"Interpolation and decimation of digital signals - A
tutorial review"
IEEE TRANSACTIONS ON ACOUSTICS, SPEECH AND
SIGNAL PROCESSING, Band ASSP-24, Nr. 2, April 1976,
Seiten 109-114, New York, USA M.G. BELLANGER et al.:
"Digital filtering by polyphase network: Application to
sample-rate alteration and filter banks"
NACHRICHTENTECHNISCHE ZEITSCHRIFT 27, Heft 11,
Seiten 425-431, Berlin, DE. W. SCHALLER:
"Verwendung der schnellen fouriertransformation in
digitalen Filtern"

(73) Patentinhaber: **Felten & Guilleaume Fernmeldeanlagen
GmbH, Thurn-und-Taxis-Strasse 10 Postfach 4943,
D-8500 Nürnberg 10 (DE)**

(72) Erfinder: **Vary, Peter, Dr., Fasanenweg 70,
D-8522 Herzogenaurach-Niederndorf (DE)**

(74) Vertreter: **Peuckert, Hermann, Philips Patentverwaltung
GmbH Billstrasse 80 Postfach 10 51 49,
D-2000 Hamburg 28 (DE)**

(56) Entgegenhaltungen: (Fortsetzung)
ARCHIV FÜR ELEKTR. UND ÜBERTR.-TECHN., Band 33,
Nr. 7/8, Juli/August 1979, Seiten 293-300, Stuttgart, DE.
P. VARY: "On the design of digital filter banks based on
a modified principle of polyphase"

ACTORUM AG

**Beschreibung**

Die Erfindung betrifft ein Verfahren zur Aufbereitung elektrischer Signale mit einer digitalen Filteranordnung, bei der ein oder mehrere Eingangssignale mittels einer dezimierenden Technik in spektrale Teilsignale aufgespalten, diese spektralen Teilsignale verarbeitet und mittels einer interpolierenden Technik zum Ausgangssignal zusammengefügt werden.

Die Art der Signalaufbereitung eines Signals ist im Sinne einer linearen Filterung oder einer Signalverbesserung oder einer Echo- bzw. Rückkopplungskompensation oder einer Signalverschleierung bzw. beliebiger Kombinationen davon, zu verstehen. Die Verarbeitung des Signals in einer digitalen Filteranordnung erfolgt zeitdiskret.

Eine zeitdiskrete lineare Filterung ist beschreibbar im Zeitbereich durch die diskrete Faltung einer Filtereingangsimpulsfolge u(k) mit einer Impulsantwort h(k) des Filters, d.h. durch die Gleichung

$$(1) \qquad y(k) = \sum_{K=0}^{k} u(k-K) \cdot h(K)$$

oder im Frequenzbereich durch die Multiplikation des Eingangsspektrums $U(\Omega)$ mit der Übertragungsfunktion $H(\Omega)$, d.h. durch die Gleichung

$$(2) \qquad Y(\Omega) = U(\Omega) \cdot H(\Omega)$$

wobei die Frequenzskala auf die Abtastfrequenz $f_A$ normiert wird $(\Omega = 2\pi \cdot f/f_A)$.

Eine Signalverbesserung ist erforderlich, wenn dem Signal eine additive Störung überlagert ist. Diese Störung kann durch akustische Hintergrundgeräusche oder durch elektrische Störungen im Übertragungskanal hervorgerufen werden. Unter der Voraussetzung einer schwachen Stationarität der Störung können mittels einer fortlaufend ausgeführten Parameter-Identifikation die stationären Intervalle d.h. die Sprachpausen und damit die Parameter der Störung erkannt werden. Mit den so gewonnenen Parametern werden die Filterkoeffizienten eines Optimalfilters berechnet (US-A-4 025 721), das den verbleibenden Restfehler nach gewissen Kriterien minimiert. Ein weiteres Zeitbereichsfilterverfahren ist aus der DT-B-2 749 132 bekannt, bei dem zur Signalverbesserung ein adaptives, digitales Transversalfilter verwendet wird, wobei die Filterkoeffizienten nach einem Gradientenalgorithmus eingestellt werden und wobei das so gebildete Schätzsignal eine möglichst gute Reproduktion des Originalsignals darstellen soll. Ein weiteres Verfahren zur Signalverbesserung ist die sogenannte spektrale Subtraktion. Dabei wird mit Hilfe der Spektraltransformation FFT (Fast Fourier Transform) das Kurzzeitspektrum des gestörten Signals nach Betrag (bzw. Leistung) und Phase ermittelt. Das Betrags- (bzw. Leistungs-) Spektrum wird im wesentlichen durch Subtraktion eines geschätzten Betrags- (Leistungs-) Spektrums der Störung korrigiert. Anschliessend wird die Phase des gestörten Signals hinzugefügt und eine inverse FFT ausgeführt. Dieses bekannte Verfahren ist beispielsweise aus einer Abhandlung in den TEEE-Transactions, Bd. ASSP-26, 1978, Seiten 471–472 bzw. Bd. ASSP-27, Seiten 113–120 entnehmbar.

Das Problem der Echo- und Rückkopplungskompensation tritt beispielsweise bei der Fernsprechübertragung auf. Durch Reflexionen an Gabelschaltungen entstehen störende Echos die mit Hilfe eines adaptiven Filters zu kompensieren sind. Im Zusammenhang mit einem sogenannten Lautfernsprecher kann zur Unterdrückung der Rückkoppelung ein adaptives Filter eingesetzt werden.

Zur Signalverschleierung kann das Signalspektrum in mehrere Frequenzbänder aufgespalten, diese untereinander vertauscht und/oder frequenzmässig in Kehrlage gebracht werden. Dadurch kann ein Übertragungskanal gegen unbefugtes Abhören gesichert werden (z.B. DT-B-1 273 002).

Der Erfindung liegt die Aufgabe zugrunde, eine digitale Filteranordnung mit einem geringen Aufwand an Mitteln zu realisieren, bei der die verschiedenen Arten der Signalaufbereitung in beliebiger Kombination gewählt werden können.

Diese Aufgabe wird durch die im Anspruch 1 gekennzeichneten Merkmale gelöst.

Gegenüber den bekannten Verfahren ist damit eine wesentliche Verbesserung der Funktionsweise und eine erhebliche Reduzierung für den Aufwand an Mitteln erreichbar.

Im weiteren wird die Erfindung anhand einer ausführlichen Beschreibung eines Ausführungsbeispiels unter Bezugnahme auf beiliegende Zeichnung veranschaulicht.

Es zeigt:

Figur 1 das Blockschaltbild der digitalen Filteranordnung gemäss der Erfindung,

Figur 2 ein weiteres Blockschaltbild der digitalen Filteranordnung mit einem zusätzlichen Referenzsignal,

Figur 3 das Prinzipschaltbild für die Anwendung der digitalen Filteranordnung zur Echo- und Rückkopplungskompensation bei einem Lautfernsprecher,

Figur 4 eine Ausführungsform der erfindungsgemässen Filteranordnung bei Verwendung zur Sprachverschleierung,

Figur 5 ein weiteres Ausführungsbeispiel für die digitale Filteranordnung nach Figur 4.

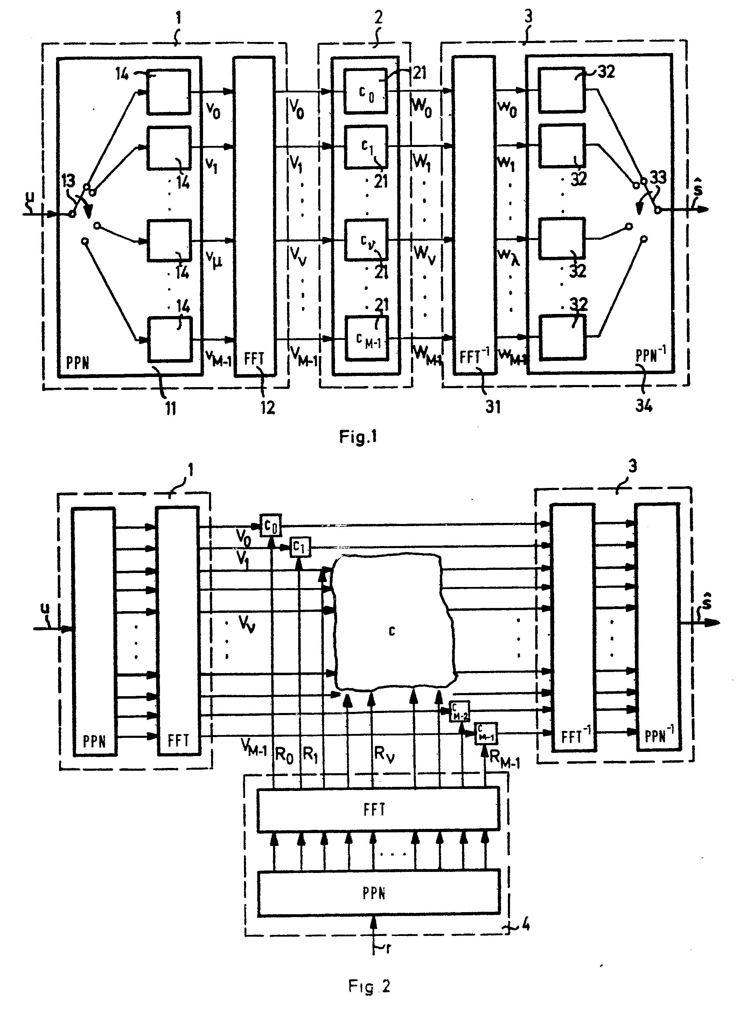

Die digitale Filteranordnung nach Figur 1 enthält eine Einrichtung 1 mittels der ein Eingangssignal u in spektrale Teilsignale $V_\nu$ in der Form komplexwertiger Tiefpasssignale aufgespalten wird. Durch die Indizierung mit dem Index ν wird ein Laufparameter (Kanal), z.B. $V_\nu$, spektrales Teilsignal für den ν-ten Kanal, bezeichnet. Diese spektralen Teilsignale $V_\nu$ werden jeweils in einer Einrichtung 2 verarbeitet. Durch die Verarbeitung in der Einrichtung 2 wird je nach Verwendungszweck das Eingangssignal u so aufbereitet, dass eine Filterung und Signalverbesserung oder eine Echo- und Rückkopplungskompensation oder eine Signalverschleierung bzw. beliebige Kombinationen davon erreichbar sind. Dabei erweist es sich als vorteilhaft, dass trotz unterschiedlichen Verwendungszwecks die Struktur der digitalen Filteranordnung beibehalten werden kann. Die Ausgangssignale $W_v$ der Einrichtung 2 werden in einer Einrichtung 3 so zu einem Ausgangssignal $\hat{s}$ zusammengefügt, dass das Ausgangssignal $\hat{s}$ gemäss dem Verwendungszweck z.B. gefiltert vorliegt.

Zur Filterung und Signalverbesserung des Eingangssignals u wird das Eingangssignal u, welches z.B. aus einem Sprachsignal s und einem additiv überlagerten Störsignal n besteht, mit Hilfe einer Filterbank (Einrichtung 1) in Frequenzbänder aufgespaltet. Eine vorteilhafte Ausführung der Filterbank ist beispielsweise aus Signal Processing, Band 2, 1980, Seiten 55–65 bekannt. Diese besteht aus einem sogenannten Polyphasennetzwerk 11, welches mit einem FFT-Prozessor 12 verbunden ist. Die Wirkungsweise einer solchen Einrichtung 1 ist beschreibbar durch M äquidistante Kanäle mit konstanter Bandbreite. Am Ausgang der Einrichtung1 entsteht an jedem der Ausgänge ein komplexwertiges Tiefpasssignal $V_v$ gemäss einer Quadratur-Bandpassfilterung mit Umsetzung in die Tiefpasslage und mit gleichzeitiger Taktreduktion. Diese Taktreduktion bzw. Dezimierung einer Abtastfrequenz für das Eingangssignal u ist beschreibbar durch einen eingangsseitig der digitalen Filteranordnung angeordneten und rotierenden Schalter 13. Bei der Realisierung kann dafür ein Eingabespeicher vorgesehen sein. Dadurch kann in vorteilhafter Weise die digitale Filteranordnung mit der theoretisch kleinstmöglichen Taktfrequenz betrieben und der Rechenaufwand verringert werden.

Das Polyphasennetzwerk 11 enthält entsprechend der Anzahl M der spektralen Teilsignale $V_v$

eine Reihe von Teilfiltern 14, deren Koeffizienten einstellbar sind. Die Wahl der Koeffizienten der Teilfilter 14 ist beschreibbar durch die Wahl der Koeffizienten eines rekursiven oder nichtrekursiven Prototyp-Tiefpasses mit dessen Impulsantwort $h_{TP}$. Durch den Frequenzgang des Prototyp-Tiefpasses wird die spektrale Auflösung bestimmt. Die Ausgangssignale $v_\mu$ der Teilfilter 14 (gefilterte Teilsignale $v_\mu$) des Polyphasennetzwerkes 11 sind beschreibbar durch folgende Gleichung

$$(3) \quad v_\mu(\rho \cdot M) = \sum_{i=0} u(\rho \cdot M - i \cdot M + \mu) \cdot h_{TP}(i \cdot M - \mu)$$

Wie aus Gleichung (3) ersichtlich, erfolgt die Berechnung zu den diskreten Zeitpunkten $k = {}_\rho \cdot M$ $({}_\rho = 0, 1, 2, \ldots)$ entsprechend einer Taktreduktion um den Faktor M (Dezimierung). Im allgemeinen kann eine Taktreduktion um einen Faktor $r \neq M$ erfolgen.

Die gefilterten Teilsignale $v_\mu$ werden mit Hilfe des Rechenverfahrens der diskreten Fourier Transformation im FFT-Prozessor 12 in komplexwertige Tiefpasssignale $V_v$ übergeführt. Für das komplexwertige Tiefpasssignal $V_v$ gilt folgende Gleichung

$$(4a) \quad V_\gamma(\rho) = \sum_{\mu=0}^{M-1} v_\mu(\rho \cdot M) \cdot e^{-j\frac{2\pi}{M} \cdot \mu \cdot v}$$

Dabei besitzt die diskrete Fourier Transformation nicht die Bedeutung einer Spektraltransformation sondern einer komplexwertigen Rechenvorschrift zur Bildung linearen Kombinationen der Zeitsignale $v_\mu$. Durch Einsetzen von Gleichung (3) in Gleichung (4a) erhält man nach einer Umformung unter Berücksichtigung der Periodizitäten der komplexen Gewichtungsfaktoren

$$(4b) \quad V\mu(\rho) = \sum_{K=0}^{k=\rho \cdot M} u(k-K) \cdot e^{-j\frac{2 \cdot \pi}{M} \cdot \mu \cdot (k-K)} \cdot h_{TP}(K); \; k = \rho \cdot M$$

Es handelt sich um komplexwertige Tiefpass-Signale, die durch komplexe Modulation

(Spektralverschiebung um $\frac{2 \cdot \pi}{M} \cdot \mu$ )

des Eingangssignals u, Tiefpassfilterung und Taktreduktion zu beschreiben sind.

Jedes der komplexwertigen Tiefpasssignale $V_v$ kann zur Geräuschreduktion einer adaptiven, komplexwertigen Filterung unterzogen werden. Im Sonderfall kann diese Filterung auch als Pegelsteuerung ausgeführt werden. Mittels der Pegelsteuerung, vorzugsweise einer adaptiven Pegelsteuerung, können jeweils Real- und Imaginärteil unabhängig voneinander geregelt werden. In der Einrichtung 2 sind dafür Einrichtungen 21 vorgesehen, mit denen beispielsweise ein pro Kanal gemeinsamer Pegelfaktor $c_v$ wählbar ist. Für die

komplexwertigen Ausgangssignale $W_v$ der Einrichtungen 21 gelten dann folgende Gleichungen

$$(5) \quad W_v(\rho) = c_v(\rho) \cdot V_v(\rho)$$

mit einem Pegelfaktor $c_v$

$$(6) \quad c_v = \sqrt{1 - \alpha_0 \cdot \frac{E_1\{|N_v|^2\}}{E_2\{|V_v|^2\}}}$$

oder

$$(7) \quad c_v = 1 - \sqrt{\alpha_0 \cdot \frac{E_1\{|N_v|^2\}}{E_2\{|V_v|\}}}$$

Die spektralen Teilsignale $V_v$ setzen sich jeweils aus Signalanteil $S_v$ und Störanteil $N_v$ gemäss

$$(8) \quad V_v = S_v + N_v$$

zusammen $E_1$ und $E_2$ sind Kurzzeiterwartungswerte mit der Bedeutung von Kurzzeitleistungen. Diese Kurzzeiterwartungswerte $E_1$ und $E_2$ werden beispielsweise durch gleitende Mittelwertbildung (Rechteckfenster mit evtl. unterschiedlichen Fensterlängen) oder aber gemäss folgender Gleichung (exponentielles Fenster)

$$(9) \quad E_i\{\times\} = G_i(\rho) = (1-\alpha_i) \cdot G_i(\rho-1) + \alpha_i \cdot \times ; \quad 0 \le \alpha_i \le 1$$

gebildet. Zur Gewichtung werden Konstanten $\alpha_i$ ($i = 0, 1, 2$) verwendet. Eine lineare Filterwirkung ergibt sich dann, wenn die komplexwertigen Tiefpasssignale $V_v$ konstant und unterschiedlich gewichtet werden.

Die Kurzzeitleistungen der Störsignale $N_v$ werden in den Sprachpausen berechnet, wobei die Zeitkonstanten der Mittelwertbildung von einem Sprachpausendetektor gesteuert werden.

Die Konstanten $\alpha_i$ bzw. die Fensterlängen können unter der Voraussetzung stationärer Störung beispielsweise derart gewählt werden, dass in jedem Kanal die Kurzzeitleistungen der komplexwertigen Zeitsignale $W_v$ nach erfolgter Pegelsteuerung mit den Kurzzeitleistungen der ungestörten Signalanteile $S_v$ übereinstimmen.

Aus den resultierenden, komplexwertigen Signalen $W_v$ wird durch inverse Operation in einem FFT-Prozessor 31 der mit einem Polyphasennetzwerk 34 verbunden ist und durch inverse Polyphasenfilterung das Ausgangssignal $\hat{s}$ zusammengesetzt. Mit Hilfe der dabei verwendeten, sogenannten interpolierenden Technik wird die Taktfrequenz der Abtastwerte wieder auf die ursprüngliche Taktfrequenz für das Eingangssignal u erhöht. Diese Takterhöhung am Ausgang der digitalen Filteranordnung ist in Figur 1 mit einem Schalter 33 umschrieben. Für die inversen Operationen gelten im folgenden die Gleichungen

$$(10) \quad w_\lambda(\rho \cdot M) = \frac{1}{M} \sum_{v=0}^{M-1} W_v(\rho) \cdot e^{+j\frac{2\pi}{M} \cdot v \cdot \lambda}$$

$$(11) \quad \times_\lambda(\rho \cdot M) = \sum_i w_\lambda((\rho - i) \cdot M) \cdot h_{TP}(i \cdot M + \lambda)$$

$$(12) \quad \hat{s}(\rho \cdot M + \lambda) = \times_\lambda(\rho \cdot M)$$

Im Vergleich zum Verfahren der spektralen Subtraktion erfordert die beschriebene digitale Filteranordnung einen geringeren Rechen- bzw. Realisierungsaufwand. Die Nachbarkanäle sind bei geeigneter Wahl der Prototyp-Tiefpass-Impulsantwort $h_{TP}$ gegenseitig entkoppelt. Durch kurze Blocklänge (z. B. $M = 32$) und minimalphasige Filterung sind geringe Verzögerungszeiten erreichbar.

Da die spektralen Teilsignale $V_v$ nach Real- und Imaginärteil trennbar sind, ist die Anwendung beispielsweise der adaptiven Pegelsteuerung getrennt für Real- und Imaginärteil möglich. Für die Teilfilter 14 bzw. 32 können rekursive und nichtrekursive Prototyp-Filter eingesetzt werden. Mit Hilfe des erfindungsgemässen Verfahrens ist eine hochwirksame Geräuschreduktion mit minimaler Verzerrung des Sprachsignals bei geringer Kanalzahl M erreichbar.

Figur 2 zeigt eine weitere Ausführungsform für das digitale Filter in dem Fall, dass ein Referenzsignal r, welches mit der Störung n korreliert ist, zur Verfügung steht. In einer weiteren Einrichtung 4 (Funktionsweise entsprechend der Einrichtung 1 nach Figur 1) wird das Eingangssignal, im vorliegenden Fall das Referenzsignal r, mittels der dezimierenden Technik in spektrale Teilsignale $R_v$ aufgespaltet. Für den Sonderfall einer reellwertigen, adaptiven Pegelsteuerung in jedem Kanal kann z.B. der gemeinsame Pegelfaktor $c_v$ nach folgender Gleichung bestimmt werden

$$(13) \quad c_v = 1 - \sqrt{\alpha_0 \cdot \frac{E_1\{|R_v|^2\}}{E_2\{|V_v|^2\}} \cdot |H_v|^2}$$

Die mittlere quadratische Übertragungsfunktion $|H_v|^2$ wird aus dem Quotienten der Kurzzeitleistungen des Störsignals $N_v$ (siehe Gleichung (8)) und des Referenzsignals $R_v$ in den Sprachpausen bestimmt. Als wesentlicher Unterschied im Vergleich zu bekannten Verfahren ist eine Stationarität oder schwache Stationarität des Geräusches keine Voraussetzung um eine hochwirksame Geräuschreduktion mit minimaler Verzerrung des Sprachsignals durchführen zu können.

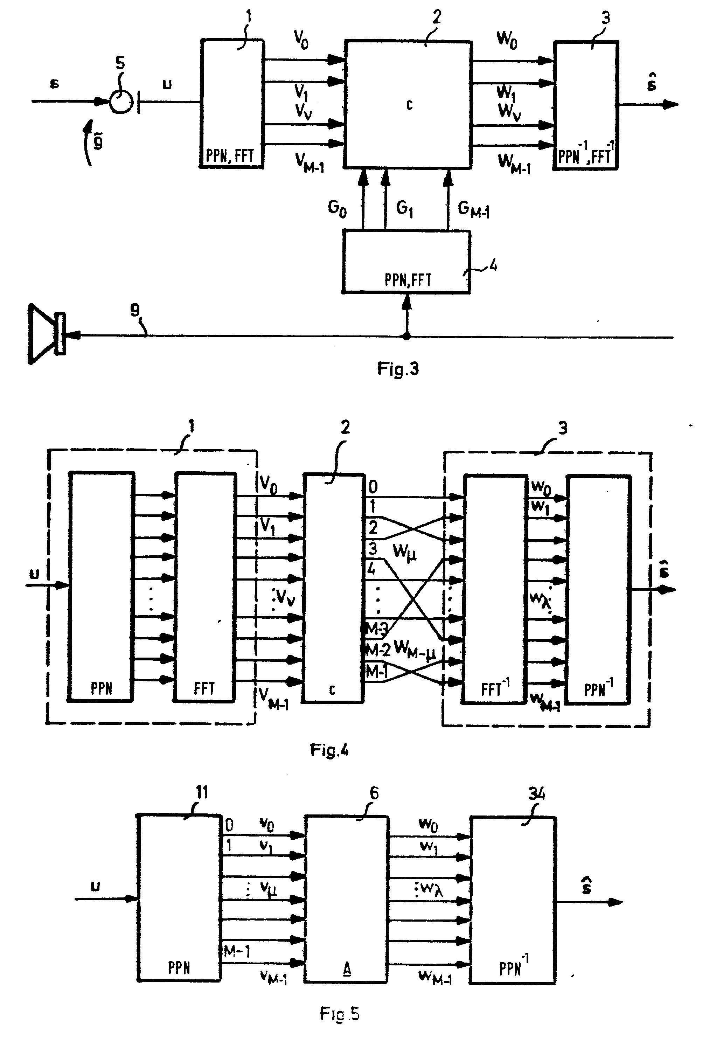

In Figur 3 ist der Einsatz der erfindungsgemässen digitalen Filteranordnung zur Echo- und Rückkopplungskompensation gezeigt. In einem Mikrofon 5 ist dem Sprachsignal s ein Echosprachsignal $\tilde{g}$ additiv überlagert. Aus dem Mikrofonsignal $(s + \tilde{g})$ wird in der digitalen Filteranordnung ein Schätzsignal $\hat{s}$ gebildet, indem die Verfahrensschritte: Aufspalten des Mikrofonsignals in spektrale Teilsignale mittels einer dezimierenden Technik, Verarbeitung dieser spektralen Teilsignale beispielsweise durch reellwertige, adaptive Pegelsteuerung und Zusammensetzung dieser spektralen Teilsignale mittels interpolierender Technik angewendet wurden.

In ähnlicher Weise wie in Figur 2 werden zur Ableitung der adaptiven, reellwertigen Pegelfaktoren ein Referenzsignal verwendet, welches im vorliegenden Fall mit einem Lautsprechersignal g identisch ist. In den Sprachpausen gilt $V_v = \tilde{G}_v$ wegen $s = 0$ bzw. $u = \tilde{g}$. Durch Messung der Kurzzeitleistungen der spektralen Teilsignale $\tilde{G}_v$ und $G_v$ kann die mittlere quadratische Übertragungsfunktion gemäss folgender Gleichung

$$(14) \quad |H_v|^2 = \frac{E_3\{|\tilde{G}_v|^2\}}{E_4\{|G_v|^2\}}$$

bestimmt werden. Es ist auch möglich, vor Gesprächbeginn ein Testsignal welches beispielsweise weisses Rauschen oder ein Mehrfrequenzsignal ist, anstelle des Lautsprechersignals g zur Messung einzuspeisen.

Figur 4 zeigt die Verwendung der erfindungsgemässen digitalen Filteranordnung zur Signalverschleierung. Zur verschleierten Übertragung von Sprachsignalen sind Einrichtungen (z.B. DT-C-1 273 002) bekannt, bei denen das Sprachfrequenzband in mehrere gleichbreite Teilbänder aufgeteilt und die Teilbänder miteinander vertauscht werden. Zur Vertauschung der Teilbänder kann beispielsweise das Verfahren der Bandumschaltung verwendet werden. Dabei trifft ein Vertauscher die Auswahl von n aus 2n Modulatoren, denen jeweils eine feste Trägerfrequenz zugeordnet ist.

Mit der in Figur 4 gezeigten digitalen Filteranordnung lässt sich eine Signalverschleierung durch Vertauschen und/oder Inversion von Frequenzbändern erreichen.

Die komplexwertigen Tiefpasssignale $V_v$ der Einrichtung 1 werden zunächst z.B. zur Geräuschreduktion, wie anhand Figur 1 beschrieben, der Einrichtung 2 zugeführt. Die komplexwertigen Zeitsignale $W_v$ an den Ausgängen der Einrichtung 2 liegen hinsichtlich ihrer Frequenzen gestaffelt vor. Die Inversion des v-ten Bandes erfolgt durch Vertauschen der Signale $W_v$ und $W_{M-v}$ oder durch Vorzeichenumkehr der Imaginärteile von $W_v$ und $W_{M-v}$. Eine Bandvertauschung kann durch Vertauschen von $W_v$ mit $W_\mu$ und $W_{M-v}$ mit $W_{M-\mu}$ für $v \neq \mu$ erreicht werden. In Figur 4 ist die Vertauschung für die komplexwertigen Zeitsignale $W_1$ mit $W_2$ und die Inversion von $W_3$ dargestellt. Schliesslich sei noch erwähnt, dass die Geräuschreduktion wahlweise vor oder nach der Signalverschleierung vorgenommen werden kann.

Figur 5 zeigt ein weiteres Ausführungsbeispiel zur Signalverschleierung mittels der digitalen Filteranordnung. Die Verarbeitung und Zuordnung der komplexwertigen Zeitsignale $W_v$ lässt sich durch vektorielle Abbildung darstellen. Dadurch ist es möglich die Verfahrensschritte FFT (Fast Fourier Transformation), Verarbeitung, Zuordnung und inverse FFT zu einer Matrixmultiplikation zusammenzufassen. Ein Vektor $\underline{v}$ dessen Komponenten die gefilterten Teilsignale $v_0$, $v_1 \ldots v_{M-1}$ sind, wird durch Multiplikation mit einer Matrix 6 unmittelbar auf den Vektor $\underline{w}$ mit den Komponenten $w_0, w_1, \ldots w_{M-1}$, entsprechend folgender Gleichung

$$(15) \qquad \underline{w} = \underline{A} \cdot \underline{v}$$

abgebildet.

Die verschiedenen Arten der Signalaufbereitung z.B. Filterung, Signalverbesserung (mit oder ohne Referenz), Echo- bzw. Rückkopplungskompensation lassen sich gleichzeitig oder in beliebiger Kombination mittels einer digitalen Filteranordnung gemäss Figur 3 und 4 realisieren.

Wird beispielsweise entsprechend zur Figur 3 eine Rückkopplungskompensation und eine Signalverbesserung gleichzeitig angestrebt, so können g und r entweder zunächst addiert und dann der Einrichtung 3 zugeführt werden oder aber es können mehrere voneinander getrennte Einrichtungen 4 vorgesehen sein.

## Patentansprüche

1. Verfahren zur Aufbereitung elektrischer Signale mit einer digitalen Filteranordnung, bei der ein oder mehrere Eingangssignale mittels einer dezimierenden Technik in spektrale Teilsignale aufgespaltet, diese spektralen Teilsignale verarbeitet und mittels einer interpolierenden Technik zum Ausgangssignal zusammengeführt werden, dadurch gekennzeichnet, dass jedes Eingangssignal (u) zur Aufspaltung in spektrale Teilsignale ($V_v$) einem Plyphasennetzwerk (11) zugeführt wird, dessen Ausgangssignale ($v_\mu$) einer diskreten Fourier Transformation (12), bei der die spektralen Teilsignale ($V_v$) nach Real- und Imaginärteil getrennt werden, unterworfen werden, dass danach die spektralen Teilsignale ($V_v$) durch adaptive Pegelsteuerung und/oder Filterung und/oder Echokompensation in beliebiger Kombination zur Filterung, Signalverbesserung, Echokompensation und/oder Signalverschleierung eines oder mehrerer Eingangssignale (u) verarbeitet werden, und dass die verarbeiteten Teilsignale ($W_v$) zum Ausgangssignal (ŝ) mit gleichzeitiger Interpolation zusammengefügt werden, indem diese Teilsignale ($W_v$) einer inversen, diskreten Fourier Transformation (31) unterworfen und einem inversen Polyphasennetzwerk (34) zugeführt werden.

2. Verfahren nach Anspruch 1, dadurch gekennzeichnet, dass eine adaptive Filterung mehrerer Eingangssignale (u) durch eine adaptive Pegelsteuerung, für die Kurzzeiterwartungswerte der spektralen Teilsignale ($V_v$) verwendet werden, vorgenommen wird.

3. Verfahren nach Anspruch 2, dadurch gekennzeichnet, dass ein oder mehrere Eingangssignale (u) nur als Referenzsignale (r, g) zur Bildung von Kurzzeiterwartungswerten verwendet werden.

4. Verfahren nach Anspruch 1, dadurch gekennzeichnet, dass zur Sprachverschleierung eine Bandvertauschung und/oder Inversion von spektralen Teilsignalen ($V_v$) durchgeführt wird.

5. Verfahren nach Anspruch 4, dadurch gekennzeichnet, dass zur frequenzmässigen Inversion der spektralen Teilsignale ($V_v$) die zueinander konjugiert komplexen Teilsignale miteinander vertauscht werden, oder dass eine Vorzeichenumkehr der Imaginärteile dieser Teilsignale vorgenommen wird.

6. Verfahren nach Anspruch 1, dadurch gekennzeichnet, dass die Verfahrensschritte Fourier Transformation (12), Verarbeitung, Bandvertauschung, Inversion und inverse Fourier Transformation (31) durch Multiplikation eines Vektors ($\underline{v}$) der Ausgangssignale des Polyphasennetzwerkes (14) mit einer Matrix (6) ersetzt werden.

## Claims

1. A method of conditioning electrical signals by a digital filter arrangement according to which at least one input signal is split into spectral sub-signals using a decimating technique, these spectral sub-signals are processed and combined to an output signal using an interpolating technique, characterized in that each input signal (u), in order to be split into spectral sub-signals ($V_v$), is applied to a polyphase network (11) whose output signals ($V_\mu$) are subjected to a discrete Fourier transform (12), the spectral sub-signals ($V_v$) being separated into real components and imaginary components, in that thereafter the spectral sub-signals ($V_v$) are processed by any combination of level controlling and/or filtering, signal improvement, echo cancelling and/or signal masking of said at least one input signal (u), and in that the processed sub-signals ($W_v$) are combined to the output signal ($\hat{s}$) whilst using simultaneous interpolation by subjecting these sub-signals ($W_v$) to an inverse discrete Fourier transform (31) and thereafter applying them to an inverse polyphase network (34).

2. A method as claimed in Claim 1, characterized in that adaptive filtering of a plurality of input signals (u) is realized by an adaptive level control using the short-term expected values of the spectral sub-signals ($V_v$).

3. A method as claimed in Claim 2, characterized in that one or a plurality of input signals (u) is or are used only as reference signals (r, g) for computing short-term expected values.

4. A method as claimed in Claim 1, characterized in that for the purpose of speech masking a band interchange and/or inversion of spectral sub-signals ($V_v$) is performed.

5. A method as claimed in Claim 4, characterized in that for the purpose of frequency-inversion of the spectral sub-signals ($V_v$) the mutually complex-conjugate sub-signals are interchanged or that a sign-inversion of the imaginary parts of these sub-signals is effected.

6. A method as claimed in Claim 1, characterized in that the steps of the method such as Fourier transform (12), processing, band exchange, inversion and inverse Fourier transform (31) are replaced by multiplying a vector (v) of the output signals of the polyphase network ($\overline{14}$) with a matrix (6).

**Revendications**

1. Procédé pour préparer des signaux électriques au moyen d'un dispositif de filtrage numérique, dans lequel un ou plusieurs signaux d'entrée sont divisés en des signaux partiels spectraux au moyen d'une technique de décimation et ces signaux partiels spectraux sont traités et combinés au moyen d'une technique d'interpolation pour former le signal de sortie, caractérisé en ce que chaque signal d'entrée (u), en vue de sa division en signaux partiels spectraux ($V_v$), est appliqué à un réseau polyphase (11), dont les signaux de sortie ($v_\mu$) sont soumis à une transformation de Fournier discrète (12), pour laquelle les signaux partiels spectraux ($V_v$) sont séparés en une partie réelle et une partie imaginaire, les signaux partiels spectraux ($V_v$) sont ensuite traités par un réglage de niveau adaptatif et/ou un filtrage et/ou une compensation d'échos en n'importe quelle combinaison pour le filtrage, l'amélioration des signaux, la compensation des échos et/ou le brouillage d'un ou de plusieurs signaux d'entrée (u), et les signaux partiels traités ($W_v$) sont combinés avec une interpolation simultanée pour former le signal de sortie ($\hat{s}$), par le fait que ces signaux partiels ($W_v$) sont soumis à une transformation de Fourier discrète inverse (31) et sont appliqués à un réseau polyphase inverse (34).

2. Procédé suivant la revendication 1, caractérisé en ce qu'un filtrage adaptatif de plusieurs signaux d'entrée (u) est effectué par un réglage de niveau adaptatif pour lequel des valeurs d'espérance à court terme des signaux partiels spectraux ($V_v$) sont utilisées.

3. Procédé suivant la revendication 2, caractérisé en ce qu'un ou plusieurs signaux d'entrée (u) ne sont utilisés que comme signaux de référence (r, g) pour former des valeurs d'espérance à court terme.

4. Procédé suivant la revendication 1, caractérisé en ce que pour brouiller les signaux de parole, on effectue une permutation de bandes et/ou une inversion de signaux partiels spectraux ($V_v$).

5. Procédé suivant la revendication 4, caractérisé en ce qu'en vue d'une inversion en fréquence des signaux partiels spectraux ($V_v$), les signaux partiels complexes réciproquement conjugués sont permutés ou une inversion de signe des parties imaginaires de ces signaux partiels est effectuée.

6. Procédé suivant la revendication 1, caractérisé en ce que les opérations impliquant la transformation de Fourier (12), le traitement, la permutation de bandes, l'inversion et la transformation de Fourier inverse (31) sont remplacés par une multiplication d'un vecteur (v) des signaux de sortie du réseau polyphase ($14\overline{)}$) par une matrice (6).

Fig.1

Fig.2

7

Fig.3

Fig.4

Fig 5